# EUROPÄISCHE PATENTSCHRIFT

(11) **EP 1 461 836 B1**
(45) Veröffentlichungstag und Bekanntmachung des Hinweises auf die Patenterteilung: **22.09.2010**
(21) Anmeldenummer: 02796520.1
(22) Anmeldetag: 23.12.2002
(51) Int. Cl.: H01L 33/52, B29C 45/14

(54) **VERFAHREN ZUM HERSTELLEN VON LUMINESZENSDIODEN MIT LICHTLEITENDEN KÖRPERN IN ZWEI ZEITLICH GETRENNTEN STUFEN**
METHOD FOR MANUFACTURING LIGHT EMITTING DIODES WITH LIGHT-GUIDING BODIES IN TWO CHRONOLOGICALLY SEPARATE STAGES
PROCEDE POUR FABRICATION DE DIODES ELECTROLUMINESCENTES AVEC CORPS DE GUIDAGE DE LUMIERE EN DEUX ETAPES SEPAREES DANS LE TEMPS

(30) Priorität: 24.12.2001 DE 10163117
(43) Veröffentlichungstag der Anmeldung: 29.09.2004
(73) Patentinhaber: odelo GmbH, 71409 Schwaikheim (DE)
(72) Erfinder: RICKING, Thorsten, 47441 Moers (DE); OLKAY, Cem, 58454 Witten (DE); WEBER, Christine, 73728 Esslingen (DE)
(74) Vertreter: Meyer, Thorsten
(86) Internationale Anmeldenummer: PCT/DE2002/004739
(87) Internationale Veröffentlichungsnummer: WO 2003/056638

(56) Entgegenhaltungen:
- JP-A- 08 335 720
- JP-A- 09 008 357
- US-A- 3 609 475
- US-A1- 2001 026 011
- PATENT ABSTRACTS OF JAPAN vol. 006, no. 052 (E-100), 7. April 1982 (1982-04-07) & JP 56 165373 A (ROHM), 18. Dezember 1981 (1981-12-18)

## Beschreibung

Verfahren zum Herstellen von Lumineszenzdioden (LED) mit lichtleitenden Körpern, aus einem vor dem endgültigen Erstarren fließfähigen Werkstoff, in einer Spritzgußform, wobei die einzelne Lumineszenzdiode mindestens einen LED-Chip und mindestens zwei elektrische - mit dem LED-Chip verbundene - Anschlüsse umfasst.

Aus der JP 1-69 020 A ist ein Verfahren zum Spritzgießen von LED's bekannt, bei dem in einem ersten Schritt zunächst in einer Vorform die Elektronikteile umspritzt werden. Hierbei erstreckt sich die Vorform bis zur vorderen Kontur des Licht abstrahlenden Lichtleitkörpers. In einem zweiten Schritt werden die erkalteten, aus der Vorform herausgenommenen LED's in eine Endform eingelegt, um die hinteren Sockelteile der LED's spritzgießtechnisch anzuformen.

Ferner ist aus der US 2001/0026011 ein Verfahren zum Herstellen von LED's bekannt, bei dem die einzelne LED mindestens einen LED-Chip und mindestens zwei, mit dem LED-Chip verbundene, elektrische Anschlüsse umfasst, wobei mindestens ein fliessfähiger Werkstoff über zwei, zueinander zeitlich versetzte Schritte, in einer Form eingebracht wird, und wobei die erste Einbringung des fliessfähigen Werkstoffes zum Umströmen des LED-Chips und eines Teils der elektrischen Anschlüsse im LED-Chip- und Anschlüssbereich zur Erzeugung eines Elektronikschutzkörpers erfolgt.

Ferner ist aus der EP 0 635 744 A2 eine LED bekannt, deren LED-Körper ein Volumen hat, das das Volumen der üblichen Standard-LEDs erheblich übertrifft. Der LED-Körper ist dazu in einer Ausführungsvariante aus mehreren Teilen zusammengefügt. Der Zusammenbau erfolgt durch Einkleben einer Standard-LED in einen zusätzlichen, größeren transparenten Lichtleitkörper, dessen Aufgabe die Lichtabstrahlung ist. Das Volumen der Standard-LED beträgt hierbei nur ein Bruchteil des Lichtleitkörpervolumens. Die Klebefuge beeinträchtigt zum einen durch die Dichteunterschiede zwischen den verklebten LED-Teilen und dem Klebstoff und zum anderen durch Gaseinschlüsse und unterschiedliche Klebefugenstärken eine Verschlechterung der Lichtabstrahlung.
In einer anderen Variante bestehen der LED-Körper und der separate Lichtleitkörper aus einem Teil. Bei diesen LEDs besteht beim Gießvorgang die Gefahr des unkontrollierbaren Schrumpfens während der Abkühl- und Aushärtungsphase. Beim einteiligen Spritzgießen ist durch die große Einspritzmenge und -geschwindigkeit ein Abreißen der Chipandrahtung bei einem Großteil der gefertigten Lumineszenzdioden kaum zu verhindern.

Der vorliegenden Erfindung liegt daher die Problemstellung zugrunde, ein Verfahren zum Herstellen von Lumineszenzdioden (LED) mit lichtleitenden Körpern zu entwickeln, bei dem nahezu alle hergestellten Lumineszenzdioden die gleichen optischen Eigenschaften aufweisen und ein Ausschuss durch Beschädigungen der einzelnen LED-Elektroniken vermieden wird.

Diese Problemstellung wird mit den Merkmalen des Hauptanspruches gelöst.

Mit dem erfindungsgemäßen Verfahren werden Lumineszenzdioden in mindestens zwei aufeinanderfolgenden Schritten z.B. spritzgießtechnisch in einer Form hergestellt. In einem ersten Schritt wird beispielsweise in einem Spritzgießwerkzeug - nach dem Einlegen der Elektronikteile - z.B. von der Rückseite der künftigen LED her eine kleine Menge Kunststoff eingebracht. Die Menge ist gerade so groß, dass die Elektronikteile vollständig umgossen oder umspritzt werden. Diese kleine Menge härtet schnell aus und bildet so einen guten Schutz der Elektronikteile. Besonders der empfindliche, dünne und freistehende Bonddraht, der die Anode mit
dem lichtemittierenden Chip verbindet, wird in seiner Lage dauerhaft fixiert und geschützt.

Noch in der Plastifizierungsphase des gerade eingebrachten Werkstoffes kann - in einem zweiten Schritt - von einer anderen Einspritzstelle aus der z.B. großvolumige Rest der Form mit neu einzubringendem Werkstoff ausgespritzt werden. Da nun keine Beschädigungsgefahr für die Elektronikteile besteht, kann der Spritzgießvorgang mit großem Volumenstrom und hoher Einspritzgeschwindigkeit erfolgen. Selbst ein hier ggf. nachgeschalteter Spritzprägevorgang kann zu keiner Beschädigung des Bonddrahtes führen. Die zeitlich nacheinander eingebrachten Werkstoffe verbinden sich zu einem homogenen optischen Körper, so dass eine berechenbare, präzise Lichtabstrahlung bei minimaler Dämpfung möglich wird.

Weitere Einzelheiten der Erfindung ergeben sich aus den Unteransprüchen und der nachfolgenden Beschreibung eines schematisch dargestellten Ausführungsbeispiels.
- Figur 1:: Lumineszenzdiode (LED) im Längsschnitt;
- Figur 2:: Draufsicht zu Figur 2;
- Figur 3:: kombinierte Lumineszenzdiode (LED) im Längsschnitt;
- Figur 4:: Draufsicht zu Figur 3;

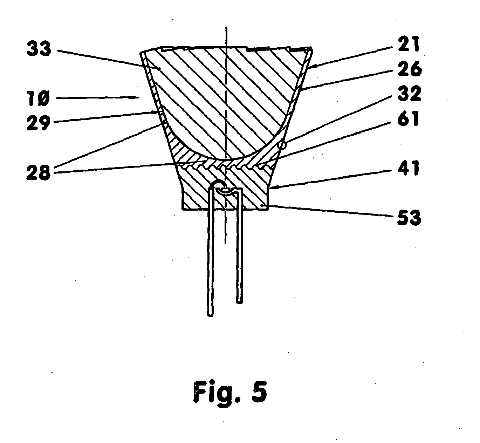

- Figur 5:: Lumineszenzdiode (LED) im Längsschnitt mit separatem Lichtleitkörper.

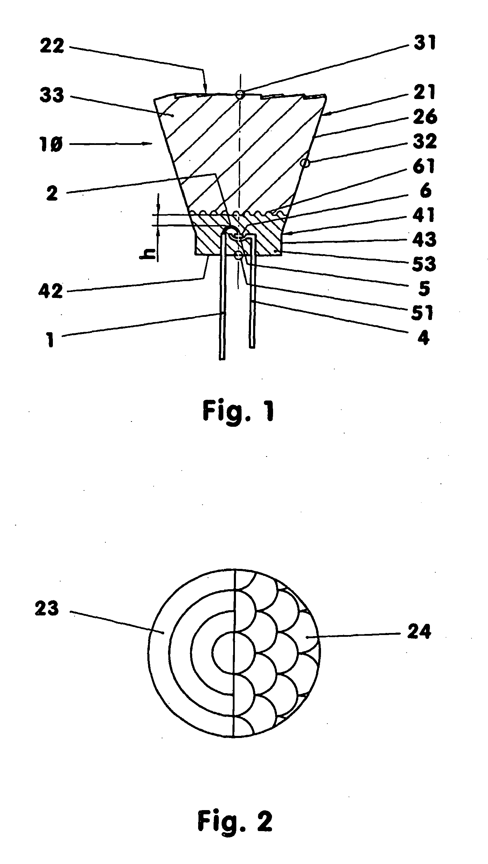

Die Figuren 1 und 2 zeigen eine großvolumige Lumineszenzdiode (LED) (10), deren lichtleitender Körper (21, 41) spritzgusstechnisch in mindestens zwei Spritzschritten hergestellt wurde.

Die in Figur 1 dargestellte LED (10) hat hierbei theoretisch einen zweigeteilten Körper. Der untere Teil des Körpers ist ein sog. Elektronikschutzkörper (41), während der obere Teil der Darstellung als Lichtleitkörper (21) bezeichnet wird.

Der Elektronikschutzkörper (41), nach Figur 1 der untere Bereich der LED (10), umgibt in der Regel die elektrischen Anschlüsse (1, 4), den lichtemittierenden Chip (6), einen Bonddraht (2) und eine Reflektorwanne (5). Letztere ist z.B. Teil der Kathode (4). In der Reflektorwanne (5) sitzt der LED-Chip (6). Der LED-Chip (6) kontaktiert über den Bonddraht (2) die Anode (1). Der Werkstoff des Elektronikschutzkörpers (41) ist hier ein spritzfähiger transparenter, z.B. eingefärbter Thermoplast (53), z.B. ein modifiziertes Polymethylmethacrylimid (PMMI).

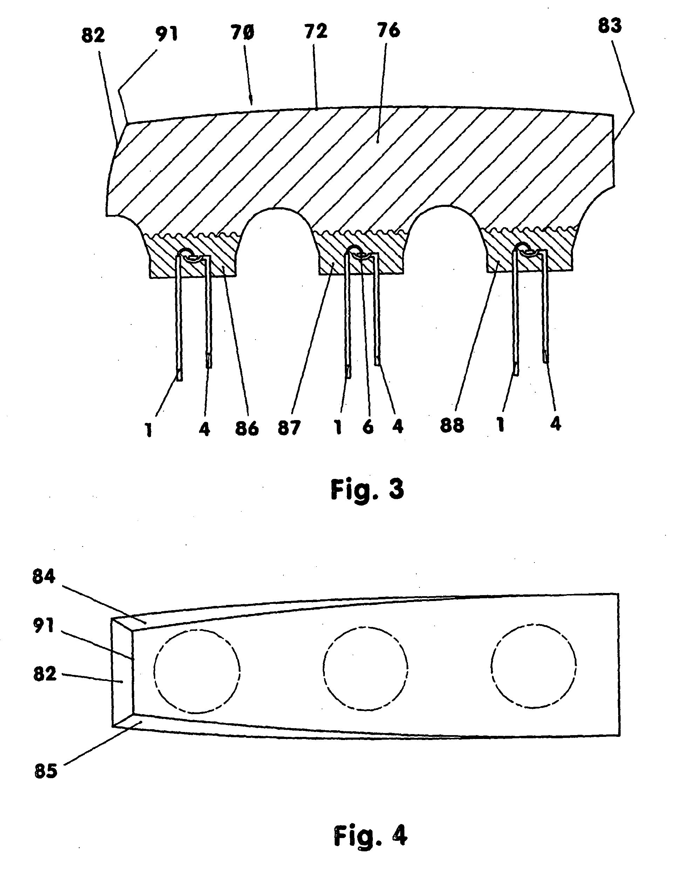

Oberhalb des Elektronikschutzkörpers (41) ist der Lichtleitkörper (21) angeordnet. Zwischen beiden Körpern (21, 41) liegt eine hier in den Figuren 1 und 3 als Wellenlinie dargestellte ggf. fiktive Trennfuge (61). Der Lichtleitkörper (21) hat beispielsweise die Form eines Kegelstumpfes. Seine dem Chip (6) gegenüber liegende Stirnfläche (22), die sog. Hauptlichtaustrittsfläche, ist nach Figur 2 jeweils halbseitig als Fresnellinse (23) und als Streufläche (24) mit Schuppenstruktur ausgebildet. Die Hauptlichtaustrittsfläche (22) kann je nach ihrem optischen Zweck eine einfache geometrische Krümmung haben, vgl. konvexe oder konkave Formen, oder eine beliebige Freiformraumfläche sein. Sie kann auch aus einer Summe einzelner regelmäßiger geometrischer Oberflächenelemente wie Kegel, Pyramiden, Halbkugeln, Torusabschnitten oder dergleichen zusammengesetzt sein.

Die seitliche Wandung des in Figur 1 gezeigten Kegelstumpfes ist eine sog. Nebenlichtaustrittsfläche (26). Sie ist hier nur beispielhaft eine Mantelfläche. Diese Fläche (26) kann glatt oder profiliert geformt sein. Auch kann sie ganz oder partiell mit einer transparenten oder lichtundurchlässigen Beschichtung versehen sein. Beispielsweise kann sie als zusätzliche Reflektorfläche galvanisch verspiegelt sein. Sie kann nahezu jede beliebige Freiformfläche annehmen. Bei glatten Raumflächen, z.B. einer Paraboloidinnenfläche, kann auch ohne separate Verspiegelung eine Vollreflektion eintreten.

Zur Herstellung der LED (10) wird in die Spritzgussform, in die z.B. von unten her die LED-Elektronikteile (1-6) hineinragen, zunächst ein erster dünnflüssiger Werkstoff (53) eingespritzt. Als Einspritzstelle (51) dient eine Öffnung in der Spritzgießform, die nach Figur 1 an einer Stelle liegt, die mit einem mit (51) bezeichneten Kreis markiert ist. Danach wird z.B. der Kunststoff (53) direkt unter der Reflektorwanne (5) eingespritzt. Theoretisch kann diese Einspritzstelle (51) an jeder beliebigen Stelle der Außenkontur des Elektronikschutzkörpers (41) sein. Die Außenkontur umfasst hier u.a. eine Bodenfläche (42) und eine bereichsweise zylindrische Mantelfläche (43), im Folgenden auch als Chip- und Anschlußbereich (42, 43) bezeichnet.

Bei diesem ersten Spritzvorgang wird gerade soviel Kunststoff (53) in die Form eingebracht, dass z.B. der Bonddraht (2) als exponiertestes Bauteil vollständig umströmt wird und der minimale Abstand (h) des Bonddrahtes (2) zur Trennfuge (61) mindestens 0,5 mm beträgt. Ggf. kann zur klaren Definition dieser Trennfuge (61) in die Form ein Stempel eingeschoben werden, der vor dem zweiten spritz- oder gießtechnischen Fertigungsschritt wieder heraus- oder zur Seite gefahren bzw. geschwenkt wird. Die zu den Elektronikteilen hin orientierte Formfläche des Stempels kann dabei u.a. zum Erzielen einer bestimmten optischen Wirkung profiliert sein.

Sobald der den Elektronikschutzkörper (41) bildende Kunststoff (53) eine zähflüssige Phase erreicht hat, das ist z.B. nur wenige Sekunden nach dem Einspritzen, wird in das Restvolumen der Form oberhalb der Trennfuge (61) z.B. der Kunststoff (33) eingespritzt. Dies geschieht z.B. über eine Einspritzstelle (31) in der Stirnfläche (22) und/oder eine Einspritzstelle (32) in der Nebenlichtaustrittsfläche (26), vgl. Figur 1. Der einströmende Kunststoff (33) verbindet sich mit dem noch zähflüssigen Kunststoff (53) des Elektronikschutzkörpers (41), ggf. löst er auch die schon erstarrte Oberfläche an. Die Vernetzung bzw. Verschmelzung in der Trennfuge (61) ist so vollständig, dass beide Kunststoffe (33, 53) einen homogenen Körper bilden. Eine Lichtbrechung im Bereich der dann verschwundenen Trennfuge (61) wird vermieden.

Alternativ hierzu kann für spezielle Anwendungsfälle die Lichtbrechung durch Verwenden von z.B. unterschiedlich dichter Kunststoffe gezielt herbeigeführt werden. Ggf. werden hierfür mehrere Schichten verschiedener Kunststoffarten eingespritzt.

Die Figuren 3 und 4 stellen eine Verbund-LED (70) im Längsschnitt und in der Draufsicht dar. Das gezeigte Ausführungsbeispiel umfasst drei Elektronikschutzkörper (86-88) jeweils einschließlich der Elektronikteile (1-6) und einen Lichtleitkörper (76). Die Elektronikschutzkörper (86-88) und der Lichtleitkörper (76) werden z.B. in einer Spritzgussform nach dem zuvor beschriebenen Verfahren hergestellt. Sie bilden nach dem Spritzvorgang eine unlösbare Einheit.

Der Lichtleitkörper (76) hat eine Hauptlichtaustrittsöffnung (72) die gegenüber den LED-Chips (6) angeordnet ist, vgl. Figur 1. An die Hauptlichtaustrittsfläche (72) schließen sich vier Nebenlichtaustrittsflächen (82-85) an.

Die dargestellte Verbund-LED (70) ist beispielsweise eine heckseitige Kraftfahrzeugsignalbeleuchtung, die im Bereich einer seitlichen Fahrzeugkante (91) integriert ist. Innerhalb der Verbund-LED (70) stellt beispielsweise der vor dem Elektronikschutzkörper (86) liegende.Bereich einen Fahrrichtungsanzeiger, der vor dem Elektronikschutzkörper (87) liegende Bereich ein Bremslicht und der vor dem Elektronikschutzkörper (88) liegende Bereich ein Rücklicht dar. Hierbei hat die in den Figuren 3 und 4 dargestellte Nebenlichtaustrittsfläche (82) die Funktion einer nebengeordneten Hauptlichtaustrittsöffnung. Sie soll zur Seite hin Licht abstrahlen. Zum Erzielen einer hohen Formtreue und Konturenpräzision kann ein Spritzprägeverfahren angewandt werden. Auch ist denkbar z.B. die Hauptlichtaustrittsflächen (22, 72) mit ihrer Linsen- und/oder Streuflächen separat herzustellen und in die Spritzgussform vorher einzulegen. Das Gleiche gilt für die Nebenlichtaustrittsflächen (26, 82-85).
Bei einer weiteren Alternative wird ein separater Lichtleitkörper (29) in die Form oberhalb der Elektronikteile (1-6) eingelegt. Dabei hat der Lichtleitkörper (29) z.B. noch unfertige Nebenlichtaustrittsflächen, d.h. seine derzeitigen Seitenflächen liegen nicht an der Form an. Dann wird zunächst der Elektronikschutzkörper (41) gegossen oder gespritzt. In einem weiteren Verfahrensschritt werden die noch leeren Zwischenräume (28) zwischen dem Elektronikschutzkörper (41) und dem Lichtleitkörper (29) sowie zwischen dem Lichtleitkörper (29) und der Form ausgefüllt. Der zuletzt eingebrachte Kunststoff (33) verschmilzt den Lichtleitkörper (29) mit dem Elektronikschutzkörper (41) unter dem Erzielen einer hohen Formgenauigkeit und bei großer Abkühlungsgeschwindigkeit. Letztere ist u.a. bedingt durch das vorherige Einlegen des großvolumigen, erkalteten Lichtleitkörpers (29), der hier nur in einer relativ dünnen Randzone mit neu eingebrachtem flüssigen Kunststoff (33) in Kontakt kommt.

Auch hier lässt sich zusätzlich ein Spritzprägeverfahrensschritt anfügen.

### Bezugszeichenliste:

- 1: Anschluss, Anode, Elektrode
- 2: Bonddraht, Aludraht

- 4: Anschluss, Kathode, Elektrode
- 5: Reflektorwanne
- 6: LED-Chip

- 10: Lumineszenzdiode (LED)

- 21: Lichtleitkörper
- 22: Stirnfläche, Hauptlichtaustrittsfläche
- 23: Fresnellinse
- 24: Streufläche

- 26: Mantelfläche, Nebenlichtaustrittsfläche, Reflektorfläche

- 28: Zwischenräume
- 29: Lichtleitkörper, separat

- 31, 32: Einspritzstellen
- 33: Werkstoff von (21)

- 41: Elektronikschutzkörper
- 42: Bodenfläche, Bereich, Teil des Chip-und Anschlußbe reichs
- 43: bereichsweise zylindrische Mantelfläche, Teil des Chip- und Anschlussbereichs

- 51: Einspritzstelle

- 53: Werkstoff von (41)

- 61: Trennfuge

- 70: LED-Verbund
- 72: Hauptlichtaustrittsfläche
- 76: Lichtleitkörper

- 82 - 85: Nebenlichtaustrittsfläche
- 86 - 88: Elektronikschutzkörper

- 91: Fahrzeug- und Verbund-LED-Kante

## Patentansprüche

1. Verfahren zum Herstellen von Lumineszenzdioden (LED) (10, 70) mit lichtleitenden Körpern (21, 41, 76, 86, 87, 88), aus einem vor dem endgültigen Erstarren fließfähigen Werkstoff (33, 53), in einer Spritzgussform, wobei die einzelne Lumineszenzdiode (10, 70) mindestens einen LED-Chip (6) und mindestens zwei, mit dem LED-Chip (6) verbunden, elektrische Anschlüsse (1, 4) umfasst,
- wobei mindestens ein fließfähiger Werkstoff (33, 53) über wenigstens zwei verschiedenen Stellen (31, 32, 51) in die Spritzgussform zueinander zeitlich versetzt eingebracht wird,
- wobei die erste Einbringung des fließfähigen Werkatoffes (53) zum Umströmen des LED-Chips (6) und der elektrischen Anschlüsse (1, 4) im LED-Chip- und Anschlußbereich zur Erzeugung eines Elektronikschutzkörpers (41, 86, 87, 88) erfolgt und
- wobei die weiteren Einbringungen eines oder mehrerer fließfähiger Werkstoffe (33) zur Erzeugung eines Lichtleitkörpers (21, 76) in Bereichen erfolgen, die außerhalb des LED-Chip-und Anschlussbereiches liegen.

2. Verfahren zum Herstellen von Lumineszenzdioden (LED) gemäß Anspruch 1, **dadurch gekennzeichnet, dass** der zeitliche Versatz zwischen dem Einbringen des ersten (53), und des zweiten fließfähigen Werkstoffes (33) kürzer ist als die Erstarrungsphase des zuerst eingebrachten Werkstoffes (53).

3. Verfahren zum Herstellen von Lumineszenzdioden (LED) gemäß Anspruch 1, **dadurch gekennzeichnet, dass** die lichtleitenden Körper (21, 41, 76, 86, 87, 88) mindestens ein Volumen von 0,3 ml aufweisen.

4. Verfahren zum Herstellen von Lumineszenzdioden (LED) gemäß Anspruch 1., **dadurch gekenntzeichnet, dass** bei der ersten Einbringung des fließfähigen Werkstoffs (53) der LED-Chip (6) und/oder seine Anschlüsse (1, 4) soweit eingebettet werden, dass die kürzeste Entfernung zum anschließend eingebrachten fließfähigen Werkstoff (33) mindestens 0,5 mm beträgt.

5. Verfahren zum Herstellen von Lumineszenzdioden (LED) gemäß Anspruch 1, **dadurch gekennzeichnet, dass** die erste Einbringung des fließfähigen Werkstoffs (53) zwischen den elektrischen Anschlüssen (1, 4) an der LED-Chipunterseite erfolgt.

6. Verfahren zum Herstellen von Lumineszenzdioden (LED) gemäß Anspruch 1, **dadurch gekennzeichnet, dass** sich die Richtung der Einbringung des zweiten fließfähigen Werkstoffes (33) von der Richtung der Einbringung des zuerst eingebrachten Werkstoffs (53) unterscheidet.

7. Verfahren zum Herstellen von Lumineszenzdioden (LED), gemäß Anspruch 1, **dadurch gekennzeichnet, dass** die Werkstoffmenge mindestens eines nachträglich eingebrachten Werkstoffs (33) mindestens fünfmal größer ist als die zuerst eingebrachte Werkstoffmenge.

8. Verfahren zum Herstellen von Lumineszenzdioden (LED) gemäß Anspruch 1, **dadurch gekennzeichnet, dass** die nacheinander eingebrachte Werkstoffe (33, 53) identisch sind.

## Claims

1. A method for manufacturing light-emitting diodes (LEDs) (10, 70) with light-guiding bodies (21, 41 76, 86, 87, 88) from a material (33, 53) which is flowable before being finally solidified, in an injection mould, the individual light-emitting diodes (10, 70) comprising at least one LED-chip (6) and at least two electrical terminals (1, 4) connected to the LED-chip (6),
- at least one flowable material (33, 53) being introduced into the injection mould via at least two different points (31, 32, 51) at times which are staggered relative to one another,
- the flowable material (53) being first introduced for flowing around the LED-chip (6) and the electrical terminals (1, 4) in the region of the LED-chip and terminal for producing a protective body for the electronics (41, 86, 87, 88) and
- one or more flowable materials (33) for producing a light-guiding body (21, 76) being further introduced in regions which are located outside the region of the LED-chip and terminal.

2. The method for manufacturing light-emitting diodes (LEDs) according to Claim 1, **characterised in that** the time offset between the introduction of the first flowable material (53) and the second flowable material (33) is shorter than the solidification phase of the material (53) introduced first.

3. The method for manufacturing light-emitting diodes (LEDs) according to Claim 1, **characterised in that** the light-guiding bodies (21, 41, 76, 86, 87, 88) have at least a volume of 0.3 ml.

4. The method for manufacturing light-emitting diodes (LEDs) according to Claim 1, **characterised in that** when the flowable material (53) is first introduced, the LED-chip (6) and/or its terminals (1, 4) are embedded to such an extent that the shortest distance from the subsequently introduced flowable material (33) is at least 0.5 mm.

5. The method for manufacturing light-emitting diodes (LEDs) according to Claim 1, **characterised in that** the flowable material (53) is first introduced between the electrical terminals (1, 4) on the LED-chip underside.

6. The method for manufacturing light-emitting diodes (LEDs) according to Claim 1, **characterised in that** the direction of introduction of the second flowable material (33) differs from the direction of introduction of the material (53) introduced first.

7. The method for manufacturing light-emitting diodes (LEDs) according to Claim 1, **characterised in that** the quantity of material of at least one subsequently introduced material (33) is at least five times greater than the quantity of material first introduced.

8. The method for manufacturing light-emitting diodes (LEDs) according to Claim 1, **characterised in that** the materials (33, 53) introduced in succession are identical.

## Revendications

1. Procédé pour fabriquer des diodes de luminescence (LED) (10, 70) avec des corps (21, 76, 86, 87, 88, 41) conducteurs de lumière, à base d'un matériau (33, 53) fluide avant la solidification définitive, dans un moule de moulage par injection, la diode de luminescence (10 ,70) individuelle comprenant au moins une puce à LED (6) et au moins deux branchements (1, 4) électriques reliés à la puce à LED (6),
- au moins un matériau (33, 53) fluide étant introduit par au moins deux endroits (31, 32, 51) différents dans le moule de moulage par injection en décalé l'un par rapport à l'autre,
- la première introduction du matériau (53) fluide s'effectuant pour le contournement de la puce à LED (6) et les branchements électriques (1, 4) dans la puce à LED et dans la zone de raccordement pour générer un corps de protection d'électronique (41, 86, 87, 88), et
- les autres introductions d'un ou plusieurs matériaux fluides (33) s'effectuant pour générer un corps conducteur de lumière (21, 76) dans des zones qui se situent à l'extérieur de la zone de puce à LED et de la zone de raccordement.

2. Procédé pour fabriquer des diodes de luminescence (LED) selon la revendication 1, **caractérisé en ce que** le décalage dans le temps entre l'introduction du premier matériau (53) et du second matériau (33) fluide est plus court que la phase de solidification du matériau (53) introduit en premier.

3. Procédé pour fabriquer des diodes de luminescence (LED) selon la revendication 1, **caractérisé en ce que** les corps (21, 41, 76, 86, 87, 88) conducteurs de lumière présentent au moins un volume de 0,3 ml.

4. Procédé pour fabriquer des diodes de luminescence (LED) selon la revendication 1, **caractérisé en ce que,** lors de la première introduction du matériau (53) fluide, la puce à LED (6) et/ou ses branchements (1, 4) électriques sont enrobés de telle sorte que la distance la plus courte au matériau (33) fluide introduit ensuite est d'au moins 0,5 mm.

5. Procédé pour fabriquer des diodes de luminescence (LED) selon la revendication 1, **caractérisé en ce que** la première introduction du matériau (53) fluide s'effectue entre les branchements (1, 4) électriques sur la face inférieure de la puce à LED.

6. Procédé pour fabriquer des diodes de luminescence (LED) selon la revendication 1, **caractérisé en ce que** la direction de l'introduction du second matériau (33) fluide se différentie de la direction de l'introduction du matériau (53) introduit en premier.

7. Procédé pour fabriquer des diodes de luminescence (LED) selon la revendication 1, **caractérisé en ce que** la quantité de matériau d'au moins un matériau (33) introduit ultérieurement est au moins cinq fois supérieure à la quantité de matériau introduite d'abord.

8. Procédé pour fabriquer des diodes de luminescence (LED) selon la revendication 1, **caractérisé en ce que** les matériaux (33, 53) introduits de façon successive sont identiques.
